Europäisches Patentamt

European Patent Office

Office européen des brevets

(11) Publication number: **0 142 177**
**B1**

(12) **EUROPEAN PATENT SPECIFICATION**

(45) Date of publication of patent specification: **20.04.88**

(51) Int. Cl.⁴: **H 03 F 1/52**

(21) Application number: **84201168.6**

(22) Date of filing: **14.08.84**

(54) Transistor protection circuit.

(30) Priority: **18.08.83 NL 8302902**

(43) Date of publication of application:
**22.05.85 Bulletin 85/21**

(45) Publication of the grant of the patent:
**20.04.88 Bulletin 88/16**

(84) Designated Contracting States:
**DE FR GB IT**

(56) References cited:
**DE-A-2 705 583**
**FR-A-2 184 580**
**FR-A-2 301 948**
**GB-A-1 323 640**
**US-A-4 078 207**

(73) Proprietor: **N.V. Philips' Gloeilampenfabrieken**
**Groenewoudseweg 1**
**NL-5621 BA Eindhoven (NL)**

(72) Inventor: **Bahlmann, Johannes Petrus Maria**
**c/o INT. OCTROOIBUREAU B.V. Prof. Holstlaan 6**
**NL-5656 AA Eindhoven (NL)**

(74) Representative: **Peters, Rudolf Johannes et al**
**INTERNATIONAAL OCTROOIBUREAU B.V. Prof.**
**Holstlaan 6**
**NL-5656 AA Eindhoven (NL)**

Courier Press, Leamington Spa, England.

## Description

The invention relates to a transistor protection circuit comprising:

—an output transistor of a first conductivity type comprising a collector, base and emitter;

—a driver transistor of the first conductivity type comprising a collector, base and emitter, the emitter being coupled to the base of the output transistor;

—a current-sensing transistor of the first conductivity type comprising a collector, base and emitter, its collector current being a measure of the collector current of the output transistor;

—a current generator for supplying a reference current, the generator output being coupled to the collector of the current-sensing transistor and;

—means coupled to the current-sensing transistor for limiting the drive current to the output transistor when the collector current of the current-sensing transistor exceeds the reference current of the current generator.

Such a circuit may be used, for example, in audio, and video-circuitry and in motor-control circuits.

Such a circuit is known from FR—A—2 184 580. In this circuit the current through the output transistor is measured by means of a current-sensing transistor whose base-emitter junction is arranged in parallel with a resistor arranged in the emitter line of the output transistor. A clamping transistor has its base coupled to the output of a current generator which is coupled to the collector of the current-sensing transistor and has its emitter coupled to the base of the driver-transistor. When the collector current of the current-sensing transistor exceeds the reference current of the current generator the clamping transistor becomes conductive so that a part of the base current of the driver-transistor is drained via the clamping transistor. A disadvantage of this known protection circuit is that the clamping transistor is a PNP-transistor, which has a comparatively low cut-off frequency. This transistor causes phase-shifts at relatively low frequencies, which in turn cause instabilities in the protection loop.

Another protection circuit is known from US—A—4 330 757. In this circuit the current through the output transistor is measured by means of a current-sensing transistor whose base-emitter junction is arranged in parallel with that of the output transistor, the collector current of the current-sensing transistor being a fraction of the collector current of the output transistor. By means of a current mirror the collector current of the current-sensing transistor is reflected to a resistance element which is arranged in parallel with the base-emitter junction of a clamping transistor, the collector of this clamping transistor being connected to the base of the driver transistor. In the case of an excessive collector current of the current-sensing transistor the clamping transistor is driven into conduction, so that what would otherwise be a part of the base current of the driver transistor is drained via the clamping transistor.

A disadvantage of this known circuit arrangement is that in integrated form it exhibits a high degree of instability in the protection loop. These instabilities are caused by phase shifts in the mirror arranged in the protection loop, which current mirror comprises PNP-transistors which have a comparatively low cut-off frequency.

Still another protection circuit is known from GB—A—1 323 640. In this circuit the driver transistor is connected to a supply voltage which is lower than that of the output transistor, in that the collector of the driver transistor is connected to a stabilized voltage via an emitter follower transistor. The stabilized voltage is derived from the higher supply voltage by means of the series arrangement of a resistor and a zenerdiode. The base of the emitter-follower transistor is connected to the junction point of the resistor and the zenerdiode. The peak value of the current through the output transistor is measured by means of a transistor, whose base-emitter junction is arranged in parallel to a resistor in the emitter-line of the output transitor via an integrating network of a resistor and a capacitor and whose collector-emitter junction is arranged in parallel with the zenerdiode. When the voltage across the capacitor exceeds the threshold voltage of the transistor the voltage at the base of the emitter-follower transistor is lowered, thereby reducing the supply current to the driver transistor so that the base current of the output transistor is reduced.

A disadvantage of this known circuit arrangement is that due to the integrating network, the protection circuit is relatively slow, so that the drive current to the output transistor is not reduced instantaneously at the occurence of an excessive current through the output transistor. A further disadvantage of the circuit is that the threshold value at which the protection circuit becomes active, is not accurately defined. Moreover, this known circuit is less suitable to be integrated because of the capacitor in the integrating network.

Therefore, it is the object of the invention to provide a transistor protection circuit which has a stable protection loop and which is suitable for manufacture in integrated form. To this end a transistor protection circuit of the type specified in the opening paragraph is characterized in that the current-sensing transistor has its base and emitter coupled to the base and the emitter, respectively, of the output transistor and in that the means comprise an emitter-follower transistor of the first conductivity type comprising a collector, base and emitter, which transistor has its base coupled to the output of the current generator and its emitter coupled to the collector of the driver transistor, whose collector-base junction becomes forward biassed when the collector current of the current-sensing transistor exceeds the reference current of the current generator.

The invention utilizes the principle that in the case when the collector current of the current-sensing transistor becomes larger than the reference current from the currant generator the voltage on the output of the current generator switches from a high to a low value, thereby forward-biassing the base-collector junction of the driver transistor via the emitter-follower transistor. The driver-transistor is then bottomed, thereby limiting the base current of the output transistor. The protection loop exhibits no instabilities, because the protection loop only comprises transistors of one conductivity-type. Moreover, the arrangement is highly suitable for being integrated.

The current generator for supplying the reference current may comprise a constant current source or a reference resistor in series with a reference-voltage source. In order to limit the base current of the output transistor when the output transistor is bottomed a limiting resistor may be arranged in the collector line of the follower transistor.

The invention will now be described in more detail, by way of example, with reference to the accompanying drawings, in which:

Figure 1 shows a first embodiment,

Figure 2 shows a first variant of the circuit shown in Figure 1,

Figure 3 shows a second variant of the circuit shown in Figure 1,

Figure 4 shows a third variant of the circuit shown in Figure 1,

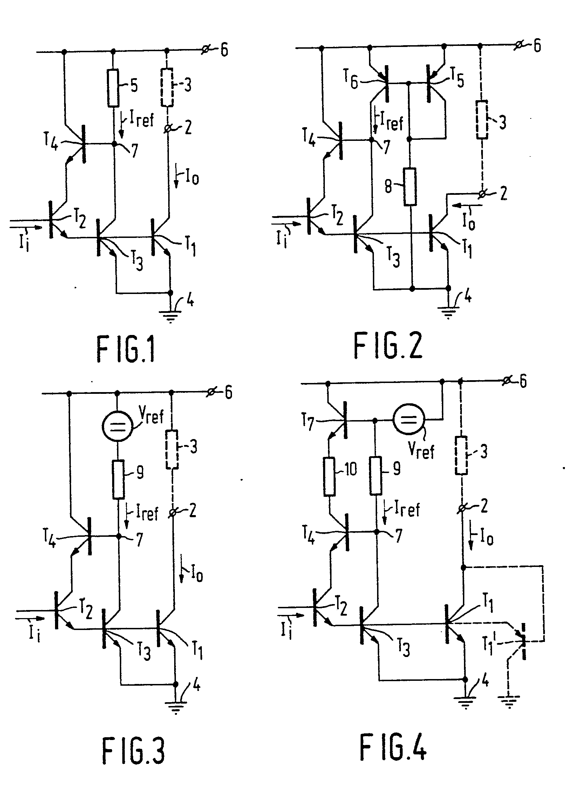

Figure 1 shows a first embodiment of the invention. In this transistor protection circuit transistor $T_1$ is the output transistor to be protected, which transistor can supply a current $I_o$ to a load 3, represented in broken lines, via the collector terminal 2. The emitter of transistor $T_1$ is connected to the negative power-supply terminal 4, which in the present example is connected to earth. The transistor $T_1$ is driven by a driver transistor $T_2$, whose emitter is connected to the base of transistor $T_1$. An input current $I_i$ is applied to the base of transistor $T_2$. In order to prevent the output transistor $T_1$ from being damaged by an excessive current the output current $I_o$ must be limited to a maximum value. The protection circuit comprises a current-sensing transistor $T_3$, whose base-emitter junction is arranged in parallel with that of the transistor $T_1$. The base-emitter area $A_3$ of the transistor $T_3$ is smaller than the base-emitter area $A_1$ of transistor $T_1$, so that the collector current of transistor $T_3$ is equal to a fraction $A_3/A_1$ of the collector current of transistor $T_1$. The collector transistor $T_3$ is coupled to the positive power-supply terminal 6 by means of a current generator 5, which supplies a reference current $I_{ref}$. Furthermore, the collector of transistor $T_3$ is connected to the base 7 of a follower transistor $T_4$, whose emitter is connected to the collector of driver transistor $T_2$ and whose collector is connected to the positive power-supply terminal 6. If the protection circuit is not activated an output current $I_o$ will flow in transistor $T_1$, which current depends on the

input current $I_i$ and on the current-gain factors of the transistors $T_2$ and $T_1$. The collector current of transistor $T_3$ is then equal to a fraction of the output current $I_o$. As long as the collector current of $T_3$ is smaller than the reference current $I_{ref}$ from the current generator 5 the transistor $T_3$ presents a load to the current generator 5. As a result of this, the voltage on the base 7 of transistor $T_4$ is comparatively high. The voltage of the emitter of transistor $T_4$ follows the voltage on the base 7 with a difference corresponding to one base-emitter voltage. As a result of this, the collector of transistor $T_1$ is at such a voltage that transistor $T_1$ conducts normally. The protection circuit is activated at the instant that the collector current of transistor $T_3$ exceeds the reference current $I_{ref}$. The current generator 5 then presents a load to transistor $T_3$. At this instant the voltage on the base 7 of transistor $T_4$ changes to a compartively low value. The voltage on the emitter of the transistor $T_4$ and hence on the collector of transistor $T_2$ then becomes so low that the base-collector junction of transistor $T_2$, which is normally cut off, is forward-biased. Transistor $T_2$ is then bottomed, so that transistor $T_2$ practically ceases to function as a current amplifier. The emitter current of transistor $T_2$ is then of the same order of magnitude as the input current $I_i$. Since upon activation of the protection circuit the collector current of transistor $T_3$ is equal to the reference current $I_{ref}$ and the collector current of transistor $T_1$ is equel to a fraction $A_1/A_3$ of the collector current of transistor $T_3$, the maximum output current will be

$$I_{omax} = \frac{A_1}{A_3} \cdot I_{ref}.$$

In the foregoing the base current which transistor $T_4$ draws from the current $I_{ref}$ has been ignored. However, this base current is generally so small that its influence on the maximum output current is minimal. Transistors $T_1$ and $T_4$ have current-gain factors $\beta$ which in practice are of the order of magnitude of 100. For a maximum output current of, for example, $I_{omax}=500$ mA the maximum collector-emitter current of the transistors $T_2$ and $T_4$ may be approximately 5 mA, so that the base current of transistor $T_4$ will be approximately 1/20 mA. For a ratio $A_1/A_3$ between the emitter areas $\approx 500$ the collector current of transistor $T_3$ will be substantially 1 mA, which is large relative to the base current of transistor $T_4$.

Instead of adjusting the ratio between the collector currents of the transistors $T_1$ and $T_3$ by means of the ratio between their emitter areas, this ratio may be adjusted by arranging a resistor in the emitter line of one of the transistors $T_1$ and $T_3$ or by arranging a resistor in both emitter lines. Upon arranging resistors in the emitter lines the ratio $I_{omax}/I_{ref}$ becomes temperature-dependent unless the ratio between the resistor values is inversely proportional to the ratio between the emitter areas.

Figure 2 shows a first variant of the circuit shown in Figure 1, similar components bearing the same reference numerals. The current generator 5 for supplying the reference currrent $I_{ref}$ comprises a current source. This current source comprises a reference resistor 8 which, in series with a PNP-transistor $T_5$ arranged as a diode, is clamped between the negative and the positive power-supply terminals 4 and 6. If the resistance of the resistor 8 is sufficiently high the current in this branch is almost wholly determined by this resistor. By means of a transistor $T_6$, whose base-emitter path is connected in parallel with that of transistor $T_5$, this current is reflected to the collector of transistor $T_3$. The present embodiment employs PNP-transistors $T_5$ and $T_6$, but these transistors do not affect the stability of the circuit because they do not form part of the feedback loop comprising the transistors $T_3$, $T_4$ and $T_2$.

The circuit operates in the same way as that in Figure 1. If the collector current of transistor $T_3$ is smaller than the collector current $I_{ref}$ of transistor $T_6$, transistor $T_3$ with its high collector-impedance constitutes a load for the current source transistor $T_6$ and the voltage on point 7 is comparatively high. However, if the collector current of transistor $T_3$ is larger than the collector current $I_{ref}$ of transistor $T_6$, transistor $T_6$ with its high collector impedance presents a load to the transistor $T_3$, which then functions as the current-source transistor. The voltage on point 7 is then comparatively low, so that transistor $T_2$ is bottomed.

A second variant of the circuit shown in Figure 1 will be described with reference to Figure 3, in which similar components bear the same reference numerals as in Figure 1. The current generator in this variant comprises a reference resistor 9, of which one terminal is connected to the collector of transistor $T_3$ and the other terminal is connected to a reference voltage $V_{ref}$. The reference current $I_{ref}$ is substantially equal to the quotient of the reference voltage and the resistance value of the resistor 9 if the reference voltage is not too low and the resistance of said resistor is sufficiently high. The circuit operates in the same way as that shown in Figures 1 and 2, the reference resistor forming a load for transistor $T_3$ when the protection circuit is activated, so that the voltage on point 7 changes and transistor $T_2$ is bottomed. By an appropriate choice of the reference voltage the operation of the protection circuit, and consequently the maximum output current $I_o$, can be made substantially temperature-independent. More particularly it can be arranged that a voltage with a positive temperature coefficient appears across the reference resistor, which coefficient is substantially equal to the positive temperature coefficient of the reference resistor, so that the reference current is substantially temperature-independent.

A third variant of the circuit shown in Figure 1 is shown in Figure 4, in which similar components bear the same reference numerals. The current generator in this variant comprises a reference resistor 9 to which a reference voltage $V_{ref}$ is applied. When the circuit is integrated the NPN-transistor $T_1$ gives rise to a parasitic PNP-transistor $T_1'$, whose collector is connected to the substrate of the integrated circuit, whose base is connected to the collector of transistor $T_1$ and whose emitter is connected to the base of transistor $T_1$. This transistor $T_1'$ is shown in broken lines in the Figure. When transistor $T_1$ is bottomed its collector voltage drops below its base voltage, so that the base-emitter junction of the parasitic transistor $T_1'$, is driven into conduction. The drive current of transistor $T_1$, which is supplied by transistor $T_2$, may then become fairly large, which demands an unnecessary amout of power. In order to limit this drive current a limiting resistor 10 is arranged in the collector line of transistor $T_4$, which limiting resistor is coupled to the positive power-supply terminal 6 via a transistor $T_7$ whose base is at the reference voltage $V_{ref}$. It is to be noted that as an alternative the limiting resistor may be connected directly to the positive power-supply terminal 6.

The invention is not limited to the embodiments described above. For example, it is possible to replace the simple emitter-follower transistor by a Darlington transistor or to arrange a diode in series with the base-emitter junction of the follower transistor. Moreover, the current generator may be constructed in various ways.

**Claims**

1. A transistor protection circuit comprising:
—an output transistor ($T_1$) of a first conductivity type comprising a collector, base and emitter;
—a driver transistor ($T_2$) of the first conductivity type comprising a collector, base and emitter, the emitter being coupled to the base of the output transistor ($T_1$);
—a current-sensing transistor ($T_3$) of the first conductivity type comprising a collector, base and emitter, its collector current being a measure of the collector current of the output transistor ($T_1$);
—a current generator (5) for supplying a reference current ($I_{ref}$), the generator output being coupled to the collector of the current-sensing transistor ($T_3$) and;
—means coupled to the current-sensing transistor ($T_3$) for limiting the drive current to the output transistor ($T_1$) when the collector current of the current-sensing transistor ($T_3$) exceeds the reference current ($I_{ref}$) of the current generator (5), characterized in that the current-sensing transistor ($T_3$) has its base and emitter coupled to the base and the emitter, respectively, of the output transistor ($T_1$) and in that the means comprise an emitter-follower transistor ($T_4$) of the first conductivity type comprising a collector, base and emitter, which transistor ($T_4$) has its base coupled to the output (7) of the current generator (5) and its emitter coupled to the collector of the driver transistor ($T_2$), whose collector-base junction becomes forward biassed when the collector current of the current-sensing transistor ($T_3$) exceeds the reference current ($I_{ref}$) of the current generator (5).

2. A transistor protection circuit as claimed in Claim 1, characterized in that the current generator comprises a constant current-source (8, $T_5$, $T_6$).

3. A transistor protection circuit as claimed in claim 1, characterized in that the current generator comprises a reference resistor (9), which has one terminal connected to the collector of the current-sensing transistor $T_3$, the other terminal being at a reference voltage ($V_{ref}$).

4. A transistor protection circuit as claimed in claim 1, 2 or 3, characterized in that a limiting resistor (10), for limiting the collector current of the driver transistor ($T_3$), is arranged in the collector line of said driver transistor ($T_3$).

5. A transistor protection circuit as claimed in Claim 4, characterized in that the collector-emitter path of a transistor ($T_7$), whose base is at a reference voltage ($V_{ref}$), is arranged in series with the limiting resistor (10).

## Patentansprüche

1. Transistorschutzschaltung mit
—einem Ausgangstransistor ($T_1$) von einem ersten Leitfähigkeitstyp mit einem Kollektor, einer Basis und einem Emitter;
—einem Treibertransistor ($T_2$) vom ersten Leitfähighkeitstyp mit einem Kollektor, einer Basis und einem Emitter, wobei der Emitter an die Basis des Ausgangstransistors ($T_1$) gekoppelt ist;
—einem Stromfühlertransistor ($T_3$) vom ersten Leitfähigkeitstyp mit einem Kollektor, einer Basis und einem Emitter, wobei der Kollektorstrom ein Maß für den Kollektorstrom des Ausgangstransistors ($T_1$) ist;
—einem Stromgenerator (5) zur Lieferung eines Bezugsstromes ($I_{ref}$), wobei der Generatorausgang mit dem Kollektor des Stromfühlertransistors ($T_3$) gekoppelt ist, und
—mit dem Stromfühlertransistor ($T_3$) gekoppelten Mitteln zur Begrenzung des Steuerstroms zum Ausgangstransistor ($T_1$), wenn der Kollektorstrom des Stromfühlertransistors ($T_3$) den Bezugsstrom ($I_{ref}$) des Stromgenerators (5) überschreitet, dadurch gekennzeichnet, daß der Stromfühlertransistor ($T_3$) mit seiner Basis und seinem Emitter an die Basis bzw. an den Emitter des Ausgangstransistors ($T_1$) gekoppelt ist, und daß die Mittel einen Emitterfolgertransistor ($T_4$) vom ersten Leitfähigkeittyp mit einem Kollektor, einer Basis und einem Emitter enthalten, wobei dieser Transistor ($T_4$) mit der Basis an den Ausgang (7) des Stromgenerators (5) und mit seinem Emitter an den Kollektor des Treibertransistors ($T_2$) gekoppelt ist, dessen Kollektor-Basisübergang in Vorwärtsrichtung vorgespannt wird, wenn der Kollektorstrom des Stromfühlertransistors ($T_3$) den Bezugsstrom ($I_{ref}$) des Stromgenerators (5) überschreitet.

2. Transistorschutzschaltung nach Anspruch 1, dadurch gekennzeichnet, daß der Stromgenerator eine Konstantstromquelle (8, $T_5$, $T_6$) enthält.

3. Transistorschutzschaltung nach Anspruch 1, dadurch gekennzeichnet, daß der Stromgenerator einen Bezugswiderstand (9) enthält, der mit einer Klemme an den Kollektor des Stromfühlertransistors ($T_3$) angeschlossen ist, während die andere Klemme eine Bezugsspannung ($V_{ref}$) führt.

4. Transistorschutzschaltung nach Anspruch 1, 2 oder 3, dadurch gekennzeichnet, daß ein Begrenzungswiderstand (10) zum Begrenzen des Kollektorstroms des Treibertransistors ($T_2$) in der Kollektorleitung dieses Treibertransistors ($T_2$) angeordnet ist.

5. Transistorschutzschaltung nach Anspruch 4, dadurch gekennzeichnet, daß der Kollektor-Emitterweg eines Transistors ($T_7$), dessen Basis eine Bezugsspannung ($V_{ref}$) führt, in Reihe mit dem Begrenzungswiderstand angeordnet ist.

## Revendications

1. Circuit de protection pour un transistor comprenant:
—un transistor de sortie ($T_1$) d'un premier type de conduction comportant in collecteur, une base et un émetteur;
—un transistor de commande ($T_2$) du premier type de conduction comportant un collecteur, une base et un émetteur, l'émetteur étant couplé à la base du transistor de sortie ($T_1$);
—un transistor de mesure de courant ($T_3$) du premier type de conduction comportant un collecteur, une base et un émetteur, son courant de collecteur constituant une mesure du courant de collecteur du transistor de sortie ($T_1$);
—un générateur de courant (5) pour fournir un courant de référence ($I_{ref}$), la sortie du générateur étant couplée au collecteur de transistor de mesure de courant ($T_3$) et
—des moyens couplés au transistor de mesure de courant ($T_3$) pour limiter le courant de commande vers le transistor de sortie ($T_1$) lorsque le courant de collecteur du transistor de mesure de courant ($T_3$) dépasse le courant de référence du générateur de courant (5), caractérisé en ce que la base et l'émetteur du transistor de mesure de courant ($T_3$) sont couplés à la base et à l'émetteur respectivement du transistor de sortie ($T_1$) et que les moyens comportent un transistor émetteur-suiveur ($T_4$) du premier type de conduction comportant un collecteur, une base et un émetteur, la base de transistor ($T_4$) étant couplée à la sortie (7) du générateur de courant (5) et son émetteur étant couplé au collecteur du transistor de commande ($T_2$), dont la jonction collecteur-base est polarisée en sens direct lorsque le courant de collecteur du transistor de mesure de courant ($T_3$) dépasse le courant de référence ($I_{ref}$) du générateur de courant (5).

2. Circuit de protection de transistor selon la revendication 1, caractérisé en ce que le générateur de courant est constitué par une source de courant constant (8, $T_5$, $T_6$).

3. Circuit de protection de transistor selon la revendication 1, caractérisé en ce que le générateur de courant est consistué par une résistance de référence 9, dont une borne est connecteur du transistor de mesure de courant ($T_9$) alors que l'autre borne est à une tension de référence ($V_{ref}$).

4. Circuit de protection de transistor selon la revendication 1, 2 ou 3, caractérisé en ce qu'une résistance de limitation (10) conçue pour la limitation de courant de collectuer du transistor de commande ($T_3$) est montée dans la ligne de collecteur dudit transistor de commande ($T_3$).

5. Circuit de protection de transistor selon la revendication 4, caractérisé en ce que le trajet de collecteur-émetteur d'un transistor ($T_7$), dont la base est à la tension de référence ($V_{ref}$), est monté en série avec la résistance de limitation (10).

FIG.1

FIG.2

FIG.3

FIG.4